# FASCICULE DE BREVET EUROPEEN

(11) **EP 2 521 884 B1**
(45) Date de publication et mention de la délivrance du brevet: **29.06.2016**
(21) Numéro de dépôt: 10807615.9
(22) Date de dépôt: 17.12.2010
(51) Int. Cl.: F24H 3/06, G06F 1/20

(54) **RADIATEUR ELECTRIQUE UTILISANT DES PROCESSEURS DE CALCUL COMME SOURCE CHAUDE**
ELEKTRISCHER HEIZKÖRPER MIT RECHNERPROZESSOREN ALS WÄRMEQUELLE
ELECTRIC RADIATOR USING CALCULATING PROCESSORS AS A HEAT SOURCE

(30) Priorité: 06.01.2010 FR 1050056
(43) Date de publication de la demande: 14.11.2012
(73) Titulaire: Qarnot Computing, 75009 Paris (FR)
(72) Inventeur: BENOIT, Paul, F-75009 Paris (FR)
(74) Mandataire: Pontet Allano & Associes
(86) Numéro de dépôt international: PCT/FR2010/052788
(87) Numéro de publication internationale: WO 2011/083244

(56) Documents cités:
- EP-A2- 1 564 627
- WO-A1-2009/156649
- US-A1- 2002 105 779
- US-A1- 2003 138 325
- US-A1- 2005 006 085
- US-A1- 2005 289 372
- US-A1- 2006 120 038
- US-A1- 2006 178 785

## Description

### DOMAINE DE L'INVENTION

L'invention se rapporte au domaine du chauffage électrique. Plus spécifiquement, elle concerne un radiateur électrique destiné au chauffage de locaux domestiques ou professionnels.

### ETAT ANTERIEUR DE LA TECHNIQUE

Parmi les types de chauffage de locaux domestiques ou professionnel, on connaît le chauffage électrique. D'un usage largement répandu, le chauffage électrique utilise généralement des radiateurs électriques placés dans les différentes pièces à chauffer. Chaque radiateur est relié au réseau électrique pour alimenter une ou plusieurs résistances électriques servant de source chaude.

Pour diffuser la chaleur dans la pièce, il existe plusieurs types de radiateur. La chaleur produite par la source chaude peut-être directement transmise à l'air ambiant, dans le cas d'un convecteur, ou par l'intermédiaire d'un ou plusieurs corps. Le transfert de chaleur entre chaque corps se réalise par une combinaison des effets de conduction, convection et de rayonnement. Dans le cas de la convection, celle-ci peut-être naturelle ou forcée. Ainsi, la source chaude peut transmettre la chaleur produite à un fluide dont la circulation est naturelle ou forcée dans le corps du radiateur, ce dernier transférant la chaleur à l'air ambiant par l'intermédiaire de sa surface extérieure.

Pour les besoins, toujours croissants, de services informatiques, on utilise des serveurs informatiques. Il s'agit d'ordinateurs ayant pour tâche principale de répondre, via un réseau informatique, à des demandes de traitements informatiques provenant de multiples utilisateurs, appelés clients. Ces serveurs, une fois configurés, ne nécessitent pas d'interaction physique avec les utilisateurs finaux. Ils peuvent donc être déportés dans des centres d'hébergements distants, appelés Datacenters, qui assurent leur fonctionnement et leur accessibilité via le réseau.

Le traitement des données par un serveur informatique est principalement assuré par un ou plusieurs processeurs. Il existe des processeurs génériques appelés unité centrale de traitement (« *central processing unit »* ou CPU, en anglais) et des processeurs spécialisés, en particulier pour les calculs graphiques (« *graphics processing unit » ou GPU, en anglais).* En exécutant les instructions qui lui sont fournies, le processeur consomme de l'énergie électrique et dégage de la chaleur. A l'instar de la résistance électrique, la plus grande partie de l'énergie consommée par le processeur est dégagée sous forme de chaleur. Cette quantité de chaleur dépend des caractéristiques techniques du processeur et de la cadence à laquelle on lui fait exécuter les instructions. Cette cadence est généralement ajustée en fonction de la capacité dont on dispose pour évacuer la chaleur produite. En effet, au-delà d'une certaine température, le processeur voit ses performances diminuer et peut surtout cesser de fonctionner. Un Datacenter doit assurer l'évacuation de cette chaleur afin de garantir le fonctionnement des serveurs qu'il héberge. Cette évacuation se fait par climatisation des salles d'hébergements ou, plus directement, des armoires de rangement des serveurs. Ce besoin de climatisation est d'autant plus important que la concentration de serveur est importante dans le Datacenter.

On connait le document D1 (US2005/289372) décrivant un dispositif pour contrôler un ordinateur et allumer ou éteindre un ventilateur de refroidissement selon le choix de l'utilisateur et pour contrôler la fréquence du CPU lorsque le ventilateur est éteint.

La présente invention a pour but un système de chauffage utilisant la chaleur produite par des ressources de calcul. Un autre but de l'invention est un transfert efficace et simplifié de cette chaleur.

### EXPOSE DE L'INVENTION

Elle concerne un radiateur électrique qui peut être utilisé pour le chauffage de locaux domestiques ou professionnels et utilisant des processeurs de calcul comme source chaude. Le radiateur peut être utilisé pour sa capacité de production de chaleur et/ou sa capacité de calcul.

Selon l'invention, le radiateur électrique individuel est tel que revendiqué.

Avec le radiateur selon l'invention, on utilise le processeur comme source chaude et comme ressource de calcul pour des machines distantes.

L'interface de contrôle est pilotée par l'utilisateur. En fonction de la consigne de l'utilisateur, cette interface de contrôle régule les processeurs de façon à obtenir une quantité d'énergie dissipée satisfaisant cette consigne. Par exemple, si l'utilisateur demande plus de chaleur, l'interface de contrôle peut commander à un ou plusieurs processeurs d'exécuter des calculs ou algorithmes prédéterminés, chaque calcul ou algorithme étant quantifié en termes d'énergie dissipée. Si l'utilisateur demande moins de chaleur, on utilise moins de processeurs ou on exécute moins de calculs. Lorsque le ou les processeurs sont utilisés par un système informatique externe, l'interface de contrôle tient compte de cette utilisation pour satisfaire la consigne de l'utilisateur. L'interface de contrôle peut être configurée de façon à transmettre au système informatique externe un signal représentant la ressource de calcul disponible dans le radiateur en fonction d'une consigne de l'utilisateur. Ainsi, les processeurs du radiateur exécutent des calculs (commandés par le système informatique externe) qui sont suffisants en nombre et/ou en complexité pour fournir la quantité d'énergie calorifique requise par l'utilisateur. Si ces calculs sont insuffisants, l'interface de contrôle complète avec des calculs prédéterminés qui sont notamment stockés en interne.

En d'autres termes, le radiateur peut être constitué de :
- un corps de chauffe au niveau duquel s'effectue le transfert de chaleur entre la source chaude et l'air ambiant, comportant un nombre N de canaux, N pouvant être égal à 0, 1 ou plus. Lorsque N est non nul, le ou les canaux sont parcourus par un fluide caloporteur permettant d'augmenter le transfert de chaleur.
- un nombre Q de processeurs interconnectés répartis sur un nombre P de circuits imprimés, appelés modules, constituant la source chaude du radiateur et une ressource de puissance de calcul.
- une interface homme-machine permettant de contrôler la puissance calorifique et calculatoire délivrée par le radiateur.
- une interface réseau permettant de connecter les ressources de calcul du radiateur aux réseaux externes.
- une alimentation électrique régulée pour alimenter les différents modules.

Le corps de chauffe peut être de différents types suivant le nombre Q de processeurs et la puissance calorifique totale W qu'ils délivrent. Il peut s'agir d'un refroidissement passif à air pour une puissance limitée, un refroidissement par circulation naturelle d'un fluide caloporteur pour une puissance moyenne ou par circulation forcée par une pompe électrique intégrée au radiateur pour une puissance importante.

Le fluide caloporteur peut provenir d'un circuit externe au radiateur.

Les Q processeurs sont répartis sur un nombre P de circuits imprimés assimilables à des carte-mères mono ou multi-processeurs appelés modules. L'ensemble des P circuits imprimés constitue une ou plusieurs unités de traitement informatique. Le radiateur propose une interface physique d'échange thermique par l'intermédiaire de blocs dissipateurs pour les différents composants électroniques des unités de traitements, en particulier les processeurs, mais également les autres composants dégageant de la chaleur : chipset, mémoires vives, mémoires de masses, alimentation. La géométrie de cette surface d'échange est paramétrée en fonction des besoins d'évacuation de chaleur des modules et de la capacité d'évacuation de chaleur du radiateur. Les modules sont caractérisés par une architecture physique adaptée à cette interface d'échange thermique. Pour optimiser l'utilisation de la surface des modules, les composants n'ayant pas besoin de dispositif de refroidissement particulier ainsi que les composants potentiellement encombrants par rapport à la géométrie du ou des blocs dissipateurs pourront être disposés sur la face arrière des modules.

Une interface homme-machine de contrôle est présente sur le radiateur permettant :
- d'allumer et d'éteindre le radiateur
- de régler la puissance électrique du radiateur
- de visualiser la consommation effective du radiateur
- de visualiser des informations synthétiques concernant l'utilisation de la puissance de calcul du radiateur.

Les modules sont interconnectés et disposent d'une interface réseau centralisée avec le réseau extérieur afin d'alimenter le radiateur en calculs à effectuer et de permettre au radiateur de communiquer les résultats des calculs effectués.

Selon une caractéristique avantageuse de l'invention, l'interface de contrôle est configurée de façon à transmettre au système informatique externe un signal représentant la ressource de calcul disponible dans le radiateur, cette disponibilité étant fonction d'une consigne d'un utilisateur.

L'alimentation en courant stabilisé fournit une puissance adaptée à la consommation des différents modules. Elle s'adapte en particulier au nombre et à la puissance des modules actifs pour le calcul et la production de chaleur. La puissance dissipée sous forme de chaleur par l'alimentation est également transférée au radiateur par le même type d'interface que les modules.

Avantageusement, le radiateur peut proposer d'autres interfaces de connexion que la simple interface réseau. Il peut s'agir d'interfaces vidéo, audio, série, parallèle permettant une utilisation du radiateur comparable à celle d'un micro-ordinateur, d'un boîtier multimédia ou d'une console de jeux vidéo en reliant des périphériques externes (écran, clavier, télécommande, manettes, enceintes audio).

De préférence, le circuit de traitement est disposé à l'extérieur du corps de chauffe, une partie du bloc dissipateur étant directement en contact avec le corps de chauffe et son éventuel fluide caloporteur à travers une paroi du corps de chauffe.

Selon un autre aspect de l'invention, il est proposé un système de chauffage comprenant :
- une pluralité de radiateurs électriques individuels distants, chaque radiateur comprenant une source chaude interne et un corps de chauffe pour effectuer le transfert de chaleur entre la source chaude du radiateur électrique et l'air ambiant, caractérisé en ce que la source chaude est constituée par au moins un circuit de traitement sur lequel est disposé au moins un processeur de calcul, ce dernier étant connecté à un bloc dissipateur pour évacuer de la chaleur dans le corps de chauffe ; et en ce qu'il comprend une interface de contrôle pour réguler la quantité d'énergie dissipée par la source chaude, une alimentation et une interface de communication permettant à un système informatique externe d'accéder audit au moins un processeur en tant que ressource de calcul,
- au moins un serveur distant relié à l'ensemble des radiateurs électriques individuels via un réseau de communication de type Internet de façon à utiliser la ressource de calcul disponible dans chaque radiateur électrique individuel.

Le radiateur selon l'invention rend la chaleur créée par le processeur immédiatement disponible dans la pièce où se situe le processeur. Au contraire, dans des systèmes informatiques de type Datacenter selon l'art antérieur où de nombreux serveurs sont concentrés dans une seule pièce, on cherche à évacuer cette chaleur vers l'extérieur. Cette évacuation est coûteuse en énergie et en moyens financiers car cela nécessite de nombreux ventilateurs ou pompes et un circuit d'évacuation souvent complexe. La présente invention résulte d'un raisonnement différent : la ressource de calcul est répartie et la chaleur produite par le processeur est directement utilisée sur le lieu de production. La production de chaleur est individualisée.

Le système selon l'invention permet d'assurer la qualité des services informatiques car il peut être réalisé selon une architecture de grilles informatiques (« *grid computing »,* en anglais). Une grille informatique s'appuie sur un ensemble de ressources informatiques potentiellement :
* partagées : elles sont mises à la disposition des différents consommateurs de la grille et éventuellement pour différents usages applicatifs.
* distribuées : pour être plus rapide, un unique service peut utiliser plusieurs ressources simultanément.
* hétérogènes : elles sont de toute nature, différant par exemple par les caractéristiques techniques ou le système d'exploitation.
* coordonnées : elles sont organisées, connectées et gérées en fonction de besoins et des contraintes par des agents informatiques, centralisés ou répartis, de coordination.
* autonomes : elles ne sont pas nécessairement contrôlées par une unité commune.
* délocalisées : elles peuvent appartenir à plusieurs sites, organisations, réseaux et se situer à différents endroits géographiques.

Ce type d'architecture physique et logicielle permet de suivre, surmonter et palier des interruptions localisées de service en s'appuyant sur les autres ressources de la grille. Concernant les ressources, une grille informatique est principalement constituée d'un ensemble de serveurs interconnectés par internet ou un réseau local.

Bien entendu, les différentes caractéristiques, formes et variantes de réalisation de l'invention peuvent être associées les unes avec les autres selon diverses combinaisons dans la mesure où elles ne sont pas incompatibles ou exclusives les unes des autres.

### DESCRIPTION DES FIGURES

La manière dont l'invention peut être réalisée et les avantages qui en découlent, ressortiront mieux de l'exemple de réalisation qui suit, donné à titre indicatif et non limitatif, à l'appui des figures annexées.
- La **figure 1** est une représentation schématique de la section transversale d'un radiateur électrique selon l'art antérieur utilisant la circulation de fluide caloporteur et une résistance électrique comme source chaude.
- La **figure 2** illustre une vue en section transversale d'un radiateur conforme à l'invention.
- La **figure 3** est une représentation schématique détaillée de la section transversale de la zone inférieure du radiateur selon l'invention.
- La **figure 4** est une représentation schématique de la disposition des composants électroniques des modules sur l'interface de transfert thermique.
- Les **figures 5, 6** et **7** sont des représentations schématiques détaillées du bloc dissipateur respectivement en vue de profil, du dessus et de face.
- La **figure 8** est une illustration d'une variante d'un radiateur selon l'invention n'utilisant pas de fluide caloporteur.
- La **figure 9** est une illustration d'une variante d'un radiateur selon l'invention utilisant un fluide caloporteur et un dispositif de circulation forcée.
- Les **figures 10** et **11** sont des représentations schématiques d'un radiateur conforme à l'invention en vue extérieure, respectivement de profil et du dessus.
- La **figure 12** décrit un système selon l'invention comprenant un ensemble de radiateurs selon l'invention et ses utilisateurs reliés entre eux via un réseau informatique.
- La **figure 13** illustre l'utilisation potentielle des radiateurs individuels comme micro-ordinateur, boîtier multimédia, console de jeux vidéo ou comme extension d'un tel système en reliant des périphériques externes (écran, clavier, télécommande, manettes, enceintes, audio).

### DESCRIPTION DETAILLEE DE CERTAINS MODES DE REALISATION DE L'INVENTION

Sur les figures, les différents éléments communs aux diverses variantes ou formes de réalisation portent les mêmes références.

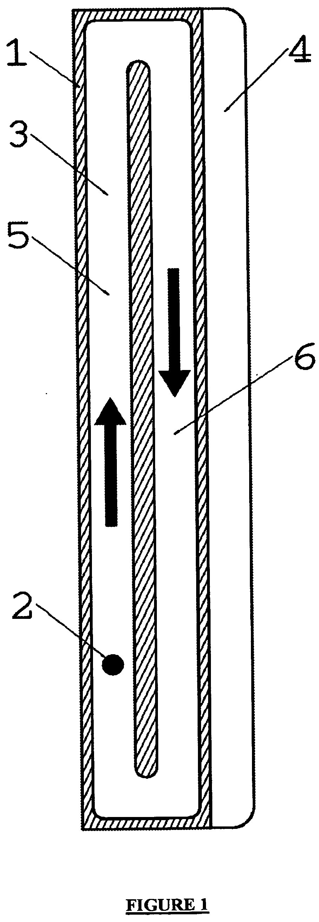

On a représenté, en relation avec la **figure 1** selon l'art antérieur, le fonctionnement schématique d'un radiateur électrique, en soi connu, utilisant la circulation de fluide caloporteur et une résistance électrique comme source chaude. Ce radiateur est constitué principalement d'un corps de chauffe **1** éventuellement modulaire et d'une résistance électrique chauffante **2** insérée dans le corps de chauffe et le traversant sur sensiblement toute sa longueur. Au sein du corps de chauffe, circule un fluide caloporteur **3** dont la nature est adaptée à la fonction thermique envisagée. Le positionnement de la résistance est fonction de la puissance de la résistance, de la nature du fluide caloporteur et de la géométrie du corps de chauffe.

Le corps de chauffe **1** peut, par exemple, être réalisé en fonte d'aluminium et, afin d'optimiser le transfert de chaleur avec l'air ambiant, est susceptible de présenter des ailettes **4** favorisant le transfert de chaleur au sein de la pièce dans laquelle un tel radiateur est implanté.

La chaleur produite par la source chaude est transmise au fluide caloporteur qui circule de manière régulière et naturelle dans le circuit du corps de chauffe grâce au gradient de température entre la zone de la source chaude du canal montant **5** et la zone de transmission de chaleur vers l'extérieur du canal descendant **6.**

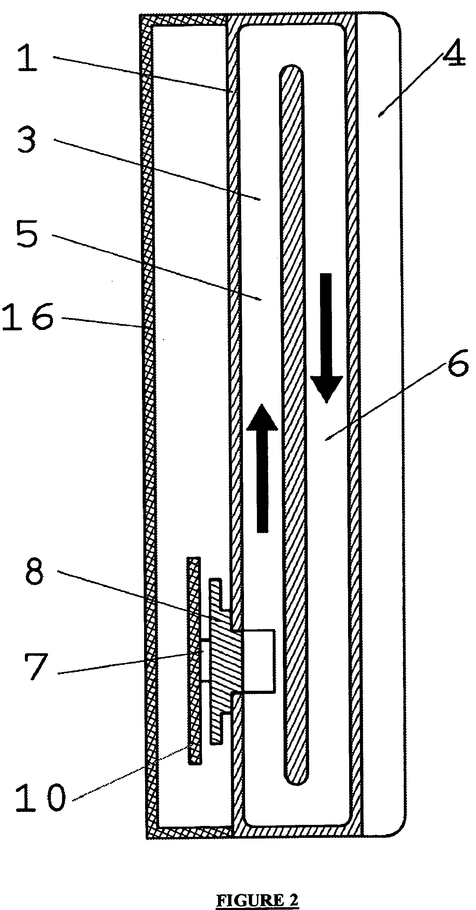

Sur la **figure 2** selon l'invention, on illustre l'utilisation de processeurs **7** comme source chaude en remplacement de la résistance électrique **2.** Les processeurs sont placés à l'extérieur du corps de chauffe et transmettent la chaleur au fluide caloporteur par l'intermédiaire d'un bloc dissipateur **8** de forte conductivité thermique vers le fluide caloporteur situé à l'intérieur du corps de chauffe. Le bloc dissipateur **8** est un bloc massif constitué de cuivre ou d'aluminium ou de tout autre matériau ayant des propriétés calorifiques adaptées au besoin d'évacuation de la chaleur. La géométrie du bloc **8** est caractérisée par une surface plane et lisse **9** à l'interface avec les processeurs et une surface optimisée pour le transfert thermique avec le fluide **3** à l'intérieur du corps de chauffe **1.** Le contact entre le corps de chauffe **1** et le bloc **8** est hermétique vis-à-vis du fluide caloporteur **3.**

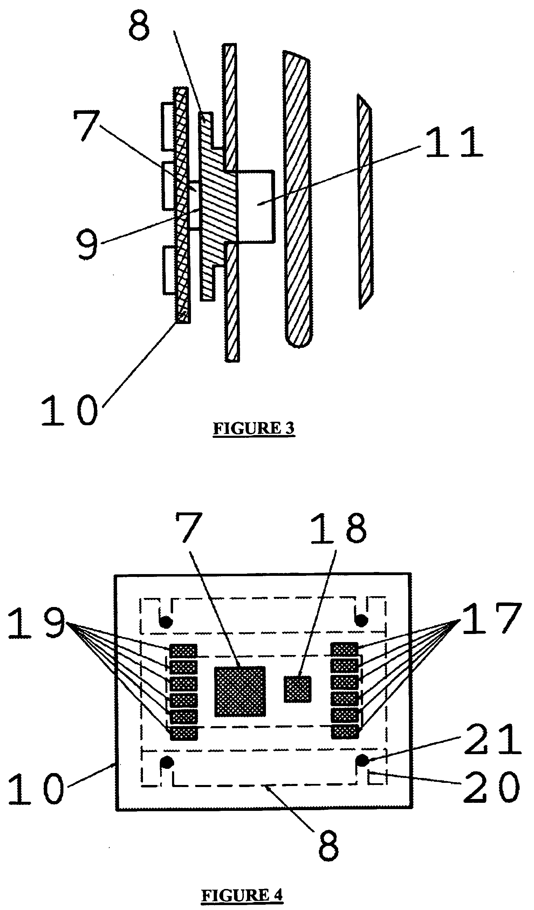

Sur la **figure 3****,** on détaille la partie inférieure du radiateur de la **figure 2****,** en particulier l'interface entre un circuit de traitement **10** et un bloc dissipateur **8.** Les composants nécessitant une évacuation de chaleur sont plaqués sur la surface externe du bloc **8.**

Sur la **figure 4**, on illustre une disposition des composants électroniques (processeur **7,** chipset **18,** mémoire vive **17,** mémoire de masse **19**) sur un circuit de traitement et la mise en contact avec un bloc dissipateur **8.** Suivant la densité des composants, l'interface d'échange thermique est soit mono-bloc ou composée de plusieurs blocs. De même qu'un bloc dissipateur peut être en contact avec les composants de plusieurs circuits de traitements, un circuit de traitement peut être « à cheval » sur plusieurs blocs dissipateurs. A titre d'illustration, on présente le dispositif de fixation **20** d'un circuit de traitement **10** au bloc **8** par l'intermédiaire de vis de fixation **21.**

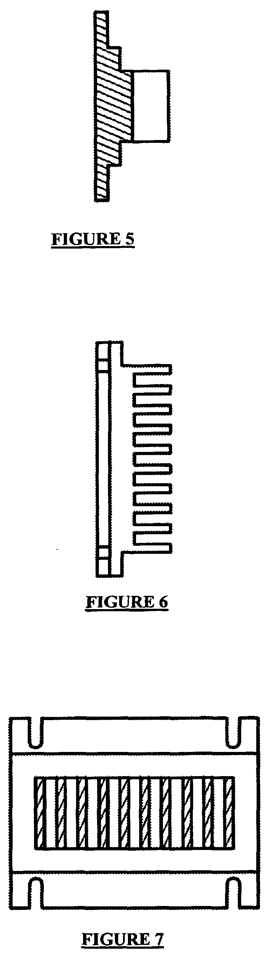

Sur les **figures 5, 6** et **7****,** on illustre les différentes vues du bloc dissipateur **8.**

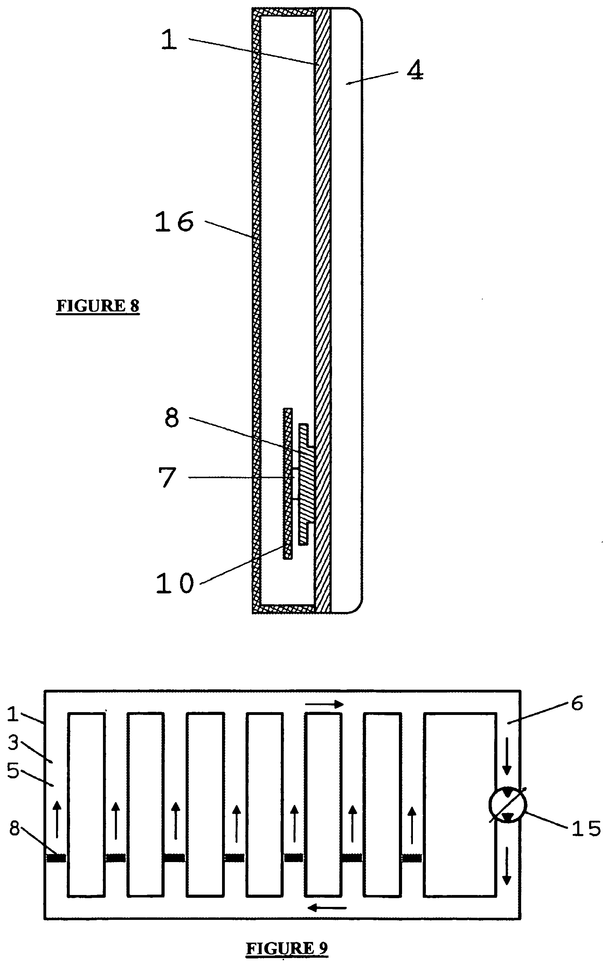

Sur la **figure 8****,** on illustre une variante de l'invention n'utilisant pas de fluide caloporteur.

Sur la **figure 9****,** on donne le schéma de fonctionnement d'une variante de l'invention utilisant un fluide caloporteur et un dispositif de circulation forcée via une pompe **15.** Le dispositif est inchangé au niveau des blocs dissipateurs. Seul le corps de chauffe **1** est modifiée pour permettre un circuit de refroidissement forcé via une pompe **15.** Ce type de circulation est assimilable à celui des radiateurs classiques à circulation forcée de fluide. La pompe **15** n'est pas nécessairement intégrée au radiateur et plusieurs radiateurs conformes à l'invention peuvent être connectés en série au même circuit de fluide caloporteur **3.** Ce circuit peut également intégrer des radiateurs classiques. L'utilité d'un tel dispositif est de permettre une évacuation de la chaleur vers l'extérieur du bâtiment lorsque l'on souhaite utiliser prioritairement la puissance de calcul des radiateurs conforme à l'invention tout en limitant la chaleur produite au sein des pièces dans lesquels ils sont implantés.

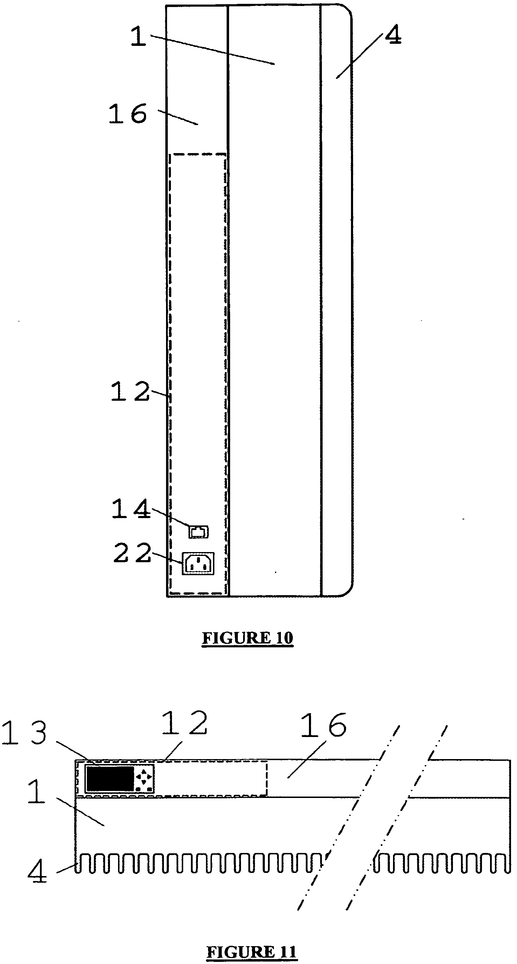

Sur les **figures 10** et **11****,** on illustre des vues extérieures d'un radiateur conforme à l'invention dans son ensemble. Elle permet d'illustrer l'interface homme-machine **13,** la prise de câble d'alimentation **22** et l'interface réseau **14.** Elle permet également d'illustrer la position du bloc d'alimentation **12** à l'intérieur du capot de protection arrière **16.**

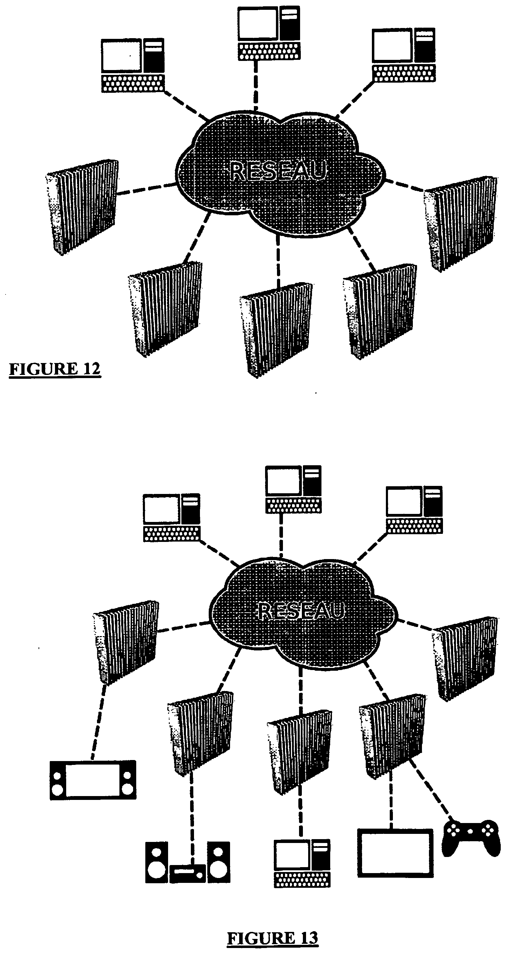

Sur la **figure 12****,** on décrit un système selon l'invention comprenant un ensemble de radiateurs selon l'invention et des utilisateurs distants reliés entre eux via un réseau informatique. L'architecture logicielle de type grille informatique permet de suivre, organiser et utiliser la ressource de calcul mise à disposition par le parc de radiateurs selon l'invention.

Sur la **figure 13****,** on illustre l'utilisation potentielle des radiateurs individuels comme micro-ordinateur, boîtier multimédia, console de jeux vidéo ou comme extension d'un tel système en reliant des périphériques externes (écran, clavier, télécommande, manettes, enceintes, audio). Les radiateurs selon l'invention présentent alors des interfaces de connexion adaptées aux périphériques envisagés (VGA, Série, Parallèle, PS2, Bluetooth, WIFI, HDMI, RCA, ...).

Bien sûr, l'invention n'est pas limitée aux exemples qui viennent d'être décrits et de nombreux aménagements peuvent être apportés à ces exemples sans sortir du cadre de l'invention.

## Revendications

1. Radiateur électrique individuel comprenant une source chaude interne et un corps de chauffe (1) pour effectuer le transfert de chaleur entre la source chaude du radiateur électrique et l'air ambiant, la source chaude étant constituée par au moins un circuit de traitement (10) sur lequel est disposé au moins un processeur (7) de calcul, ce dernier étant connecté à un bloc dissipateur (8) pour évacuer de la chaleur dudit au moins un processeur (7) de calcul vers le corps de chauffe (1) ; et le radiateur comprenant une interface de contrôle (13) utilisateur pour réguler la quantité d'énergie dissipée par la source chaude en contrôlant le nombre de processeurs utilisés et les calculs exécutés par ledit au moins un processeur de façon à obtenir une quantité d'énergie dissipée conformément à une consigne de l'utilisateur, **caractérisé en ce que** l'interface de contrôle utilisateur est configurée de façon à transmettre à un système informatique externe un signal représentant la ressource de calcul disponible dans le radiateur en fonction d'une consigne de l'utilisateur, ledit au moins un processeur du radiateur exécutant des calculs commandés par le système informatique externe qui sont suffisants en nombre et/ou en complexité pour fournir la quantité d'énergie calorifique requise par l'utilisateur, si ces calculs sont insuffisants, l'interface de contrôle complète avec des calculs prédéterminés qui sont notamment stockés en interne, une alimentation (12) et une interface de communication permettant au système informatique externe (14) d'accéder audit au moins un processeur en tant que ressource de calcul.

2. Radiateur selon la revendication 1, **caractérisé en ce que** le corps de chauffe est parcouru par un fluide caloporteur (3) circulant naturellement.

3. Radiateur selon la revendication 1, **caractérisé en ce que** le corps de chauffe est parcouru par un fluide caloporteur (3) de manière forcée par une pompe électrique (15) intégrée au radiateur.

4. Radiateur selon l'une des revendications précédentes, **caractérisé en ce que** le corps de chauffe est parcouru par un fluide caloporteur (3) provenant d'un circuit externe au radiateur.

5. Radiateur selon l'une des revendications précédentes, **caractérisé en ce que** le circuit de traitement (10) est relié à des périphériques externes et forme un micro-ordinateur, boîtier multimédia, console de jeux vidéo ou une extension d'un tel système.

6. Radiateur selon l'une des revendications précédentes, **caractérisé en ce que** le circuit de traitement (10) est disposé à l'extérieur du corps de chauffe, une partie du bloc dissipateur étant directement en contact avec le fluide caloporteur à travers une paroi du corps de chauffe.

7. Système de chauffage comprenant :
- une pluralité de radiateurs électriques individuels distants, chaque radiateur étant tel que défini dans l'une quelconque des revendications précédentes,
- au moins un serveur distant relié à l'ensemble des radiateurs électriques individuels via un réseau de communication de type Internet de façon à utiliser la ressource de calcul disponible dans chaque radiateur électrique individuel.

## Patentansprüche

1. Elektrisches Einzelheizgerät, umfassend eine innere warme Quelle und einen Heizköper (1), um die Wärmeübertragung zwischen der warmen Quelle des elektrischen Heizgerätes und der Raumluft zu vollziehen,
wobei die warme Quelle durch wenigstens eine Verarbeitungsschaltung (10), an der wenigstens ein Rechenprozessor (7) angeordnet ist, gebildet ist, wobei letzterer an einen Ableitblock (8) angeschlossen ist, um Wärme von dem wenigstens einen Rechenprozessor (7) zu dem Heizkörper (1) abzuführen;
und wobei das Heizgerät eine Benutzersteuerschnittstelle (13) umfasst, um die durch die warme Quelle abgeleitete Energiemenge dadurch zu regulieren, dass die Anzahl von verwendeten Prozessoren und die durch den wenigstens einen Prozessor durchgeführten Berechnungen derart gesteuert werden, dass eine abgeleitete Energiemenge entsprechend einem Sollwert des Benutzers erhalten wird,
**dadurch gekennzeichnet, dass** die Benutzersteuerschnittstelle derart ausgelegt ist, dass sie an ein externes Computersystem ein Signal überträgt, das die in dem Heizgerät in Abhängigkeit von einem Sollwert des Benutzers verfügbare Rechenressource darstellt, wobei der wenigstens eine Prozessor des Heizgerätes durch das externe Computersystem gesteuerte Berechnungen durchführt, die hinsichtlich Anzahl und/oder Komplexität ausreichend sind, um die durch den Benutzer benötigte Wärmeenergiemenge bereitzustellen, wenn diese Berechnungen unzureichend sind, vervollständigt die Steuerschnittstelle mit vorbestimmten Berechnungen, die insbesondere intern gespeichert sind,
wobei eine Versorgung (12) und eine Kommunikationsschnittstelle dem externen Computersystem (14) ermöglichen, auf den wenigstens einen Prozessor als Rechenressource zuzugreifen.

2. Heizgerät nach Anspruch 1, **dadurch gekennzeichnet, dass** der Heizkörper von einem natürlich umlaufenden Wärmeübertragungsmittel (3) durchströmt wird.

3. Heizgerät nach Anspruch 1, **dadurch gekennzeichnet, dass** der Heizkörper von einem Wärmeübertragungsmittel (3) mittels einer Elektropumpe (15), die in das Heizgerät integriert ist, zwangsdurchströmt wird.

4. Heizgerät nach einem der vorhergehenden Ansprüche, **dadurch gekennzeichnet, dass** der Heizkörper von einem von einem außerhalb des Heizgerätes befindlichen Kreis kommenden Wärmeübertragungsmittel (3) durchströmt wird.

5. Heizgerät nach einem der vorhergehenden Ansprüche, **dadurch gekennzeichnet, dass** die Verarbeitungsschaltung (10) mit externen Peripheriegeräten verbunden ist und eine(n) Mikrocomputer, Multimedia-Box, Videospielkonsole oder eine Erweiterung eines solchen Systems bildet.

6. Heizgerät nach einem der vorhergehenden Ansprüche, **dadurch gekennzeichnet, dass** die Verarbeitungsschaltung (10) außerhalb des Heizkörpers angeordnet ist, wobei ein Teil des Ableitblocks durch eine Wand des Heizkörpers direkt in Kontakt mit dem Wärmeübertragungsmittel ist.

7. Heizsystem, umfassend:
- eine Vielzahl von entfernten elektrischen Einzelheizgeräten, wobei jedes Heizgerät so ist wie in einem der vorhergehenden Ansprüche definiert,
- wenigstens einen entfernten Server, der über ein Kommunikationsnetz vom Typ Internet mit allen elektrischen Einzelheizgeräten verbunden ist, um die in jedem elektrischen Einzelheizgerät verfügbare Rechenressource zu nutzen.

## Claims

1. A single electric radiator comprising an internal heat source and a heating body (1) for performing heat transfer between the heat source of the electric radiator and ambient air,
the heat source being formed by at least one processing circuit (10) whereon at least one computing processor (7) is provided, the latter being connected to a dissipating block (8) to remove heat of said at least one computing processor (7) towards the heating body (1);
and the radiator comprising an user control interface (13) for controlling the amount of energy dissipated by the heat source by controlling the number of processors used and the calculations executed by said at least one processor so as to obtain an amount of dissipated energy meeting an user's setpoint, **characterised in that**
the user control interface is configured so as to transmit to an external computer system a signal representing the computing resource available in the radiator depending on a user's setpoint, said at least one processor of the radiator executing calculations ordered by the external computer system which are sufficient in number and/or in complexity to provide the amount of calorific energy required by the user, if these calculations are insufficient, the control interface completes with predetermined calculations which are in particular stored internally,
a power supply (12) and a communication interface enabling an external computer system (14) to access said at least one processor as a computing resource.

2. The radiator according to claim 1, **characterised in that** a naturally flowing heat transfer fluid (3) travels in the heating body.

3. The radiator according to claim 1, **characterised in that** a heat transfer fluid (3) travels in the heating body, in a forced way by an electric pump (15) integrated to the radiator.

4. The radiator according to one of the preceding claims, **characterised in that** a heat transfer fluid (3) from a circuit external to the radiator travels in the heating body.

5. The radiator according to one of the preceding claims, **characterised in that** the processing circuit (10) is connected to external peripherals and forms a micro-computer, a multimedia box, a video game console or an extension of such a system.

6. The radiator according to one of the preceding claims, **characterised in that** the processing circuit (10) is provided outside the heating body, a part of the dissipating block directly contacting the heat transfer fluid through a wall of the heating body.

7. A heating system comprising:
- a plurality of single remote electric radiators, each radiator being as defined in one of the preceding claims,
- at least one remote server connected to all the single electric radiators via an Internet type communication network so as to use the computing resource available in every single electric radiator.
